(19) **Europäisches Patentamt / European Patent Office / Office européen des brevets**

(11) **EP 2 226 640 B1**

(12) **EUROPEAN PATENT SPECIFICATION**

(45) Date of publication and mention
of the grant of the patent:
**31.07.2013 Bulletin 2013/31**

(51) Int Cl.:
***G01R 23/16*** *(2006.01)*

(21) Application number: **09154247.2**

(22) Date of filing: **03.03.2009**

(54) **Spectral analysis**

Spektralanalyse

Analyse spectrale

(84) Designated Contracting States:
**DE FR GB**

(43) Date of publication of application:
**08.09.2010 Bulletin 2010/36**

(73) Proprietors:
- **Mitsubishi Electric R&D Centre Europe B.V.**
 **The Surrey Research Park**
 **Guildford, Surrey GU2 7YD (GB)**
 Designated Contracting States:
 **GB**
- **Mitsubishi Electric Corporation**
 **Chiyoda-ku**
 **Tokyo 100-8310 (JP)**
 Designated Contracting States:
 **DE FR**

(72) Inventor: **Szajnowski, Dr. Wieslaw Jerzy**
**Guildford, Surrey GU1 2AR (GB)**

(74) Representative: **HOFFMANN EITLE**
**Patent- und Rechtsanwälte**
**Arabellastrasse 4**
**81925 München (DE)**

(56) References cited:
**EP-A- 1 378 854     EP-A- 1 496 410**
**US-A- 5 301 123**

- **SZAJNOWSKI W J ET AL: "Implicit averaging and delay determination of random binary waveforms" IEEE SIGNAL PROCESSING LETTERS IEEE USA, vol. 9, no. 7, July 2002 (2002-07), pages 193-195, XP002541387 ISSN: 1070-9908**

## Description

Field of the Invention

This invention relates to a method and apparatus intended for spectral analysis of a broad class of signals of deterministic or stochastic nature in real time for the purpose of signal recognition and classification.

Background of the Invention

Physical phenomena of interest in science and engineering are usually observed and interpreted in terms of amplitude-versus-time functions, referred to as signals or waveforms. The instantaneous value of the function, the amplitude, may represent some physical quantity of interest (an observable), such as displacement, velocity, pressure, temperature etc. The argument of the function, the time, may represent any appropriate independent variable, such as relative time, distance, spatial location, angular position etc.

Many physical phenomena are of non-deterministic nature, i.e. each experiment produces a unique time series which is not likely to be repeated exactly and thus cannot be accurately predicted. An important class of time series, stationary time series, exhibit statistical properties which are invariant throughout time, so that the statistical behaviour during one epoch is the same as it would be during any other.

There are two distinct, yet broadly equivalent, approaches to time series representation and analysis: the time-domain methods and the frequency-domain (or spectral) methods. Conventional non-parametric frequency-domain methods are either based on the concept of 'periodogram' or they employ some form of Fourier transform to convert correlation functions into power spectra.

Although many waveforms encountered in practical applications are clearly non-stationary, most spectral analysis techniques are based on the implicit assumption that waveforms of interest are stationary. Therefore, conventional spectral methods are not well suited to examining signals comprising interference of impulsive or transient nature encountered in industrial and/or multiuser applications.

US 5,301,123 discloses a zero crossing based spectrum analyzer, a method that samples zero crossings of a signal waveform containing only real zeros and uses this information to determine the discrete Fourier Transform coefficients. A band-limited signal represented by real and complex zeros is converted by invertible techniques to a signal that contains only real (physical) zeros. This converted signal is applied as the input to the zero crossing based spectrum analyzer.

"Implicit Averaging and Delay Determination of Random Binary Waveforms" by W.J. Szajnowski and P.A. Ratliff in IEE SIGNAL PROCESSING LETTERS, VOL. 9, NO. 7, July 2002 shows that for broad class of random binary processes, the mean of a binary process, conditioned on its zero crossings, is proportional to the derivative of the correlation function of that process. This is specific mean, referred to as the implicit mean, can be used both to characterize a random binary waveform and to determine its delay. The proposed empirical estimator of the implicit mean is unbiased, and its variance depends on the number of selected trajectories of the waveform being processed and the correlation between those trajectories.

Summary of the Invention

According to the present invention, there is provided a spectrum analyser as set out in Claim 1.

The present invention also provides a method of processing a signal to perform spectrum analysis as set out in Claim 7.

Optional features are set out in the dependent claims.

Brief Description of the Drawings

Fig. 1 is a functional block diagram of a prior-art crosslator system.

Fig. 2a is an overlay of segments of a signal processed in a prior-art crosslator system.

Fig. 2b depicts the crosslation function $C(\tau)$ representing the signal being processed.

Fig. 3 depicts an example of a signal, a binary waveform obtained from that signal by hard limiting, and a sequence of bipolar impulses representing the derivative of the binary waveform.

Fig. 4 is one example of a crosslator suitably modified for the use in a spectrum analyser constructed in accordance with the first and second embodiments of the present invention.

Fig. 5 is a block diagram of a crosslation-based spectrum analyser CSS constructed in accordance with a first embodiment of the invention.

Fig. 6 depicts symbolically results of the basic operations performed by the crosslation-based spectrum analyser of Fig. 5.

Fig. 7 is a block diagram of another crosslation-based spectrum analyser constructed in accordance with a second embodiment of the invention.

Fig. 8 depicts symbolically results of the basic operations performed by the crosslation-based spectrum analyser of Fig. 7.

In the following, there is described a spectrum analyser, comprising a crosslator operable to process an input signal to produce discrete-time crosslation function values for the input signal; and a time-domain to frequency-domain transformer operable to transform the discrete-time crosslation function values to generate frequency-dependent values. The crosslator is arranged to operate in real-time by processing the input signal by detecting the input signal values in respective time windows, each window being of a predetermined time duration, and processing the values in each window to generate discrete-time crosslation function values for each window. Likewise, the time-domain to frequency-domain transformer is arranged to transform the discrete-time crosslation function values for each time window into the frequency domain.

Underlying Theory

Before describing embodiments of the present invention, the theory underlying the operation of the embodiments will be described first to assist understanding.

The embodiments make use of a technique known as crosslation. This technique has been disclosed for time-domain processing in a number of Patents; see, for example, US 7,120,555, US 6,539,320 and US 7,216,047.

A brief summary of the crosslation technique is given below for reference purposes, in order to facilitate the understanding of its specific characteristics that are relevant to embodiments of the present invention.

In accordance with the crosslation algorithm, a signal s(t) of interest is examined to determine the time instants at which its level crosses zero, either with a positive slope (an upcrossing) or with a negative slope (a downcrossing). The time instants of these crossing events are used to obtain respective segments of the signal s(t), the segments having a predetermined duration. The segments corresponding to zero upcrossings are all summed, and the segments corresponding to zero downcrossings are all subtracted from the resulting sum. The combined segments are represented by an odd function, referred to as the crosslation function that contains compressed information regarding the statistical characteristics of the signal being analyzed.

To explain crosslation further, consider a continuous zero-mean signal s(t); there are time instants at which the signal crosses a zero level with a positive or negative slope. These time instants

$$t_1, t_2, \ldots, t_k, \ldots, t_K$$

will form a set of zero upcrossings and downcrossings. Suppose that any one of the zero crossings of s(t), say that at $t_k$, has been selected. Consider now the primary signal s(t) before and after its zero crossing, $s(t_k) = 0$, occurring at this selected time instant $t_k$.

For the purpose of this analysis, it is convenient to introduce the notion of signal *trajectory*, associated with a zero crossing of the signal. For a zero crossing occurring at $t_k$, the signal trajectory $s_k(\tau)$ is determined from

$$s_k(\tau) = s(t_k + \tau); \qquad k = 1, 2, \ldots K$$

where $\tau$ is (positive or negative) *relative time*. Accordingly, each trajectory $s_k(\tau)$ is simply a time-shifted copy of the primary signal s(t). The time shift, different for each trajectory, results from the time transformation

$$\tau = t - t_k; \qquad\qquad k = 1, 2, \ldots K,$$

used for transporting signal trajectories from the time domain (t) to the tau-domain ($\tau$).

Accordingly, a single primary signal s(t) can generate successively a plurality of trajectories $\{s(t_k + \tau); k = 1, 2, \ldots K\}$ that are mapped (by the time shifts) into another set of trajectories $\{s_k(\tau); k = 1, 2, \ldots K\}$, each being a function of relative time $\tau$ in the tau-domain. Such construction makes all zero crossings of a primary signal s(t) equivalent in the sense that they, being aligned in time, jointly define the same origin $\tau = 0$ of the relative time $\tau$.

The duration of each trajectory used for further signal processing is determined by a preselected *trajectory frame*. In addition, within this frame, a specific location is selected (e.g., somewhere close to the middle) to become the origin of the relative time $\tau$.

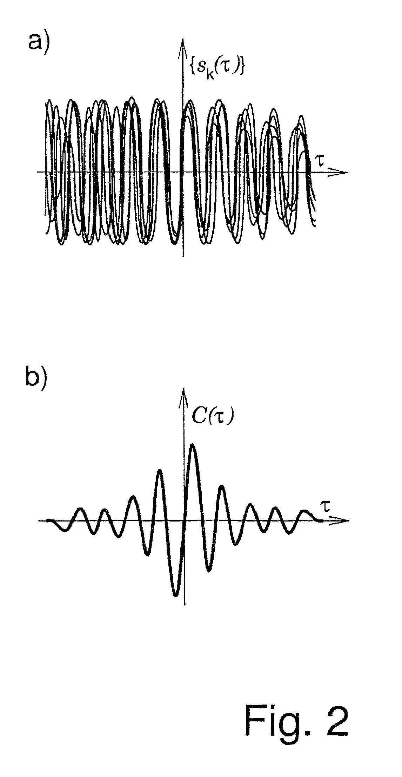

When the above time-shifting procedure has been replicated for each of the selected K zero crossings, the trajectory frame in the tau-domain will have contained K signal trajectories, and the positions of the corresponding zero crossings will have coincided with the relative time origin, $\tau = 0$. For illustrative purposes, Fig. 2a depicts an overlay of time-aligned signal trajectories associated with zero upcrossings.

K signal trajectories $\{s(t_k + \tau), k = 1, 2, \ldots, K\}$, associated with zero crossings $\{s(t_k) = 0\}$ of a primary signal s(t), are used to determined a crosslation function $C(\tau)$, defined by

$$C(\tau) = \frac{1}{K}\sum_{k=1}^{K}(-1)^{\psi}s(t - t_k) = \frac{1}{K}\sum_{k=1}^{K}(-1)^{\psi}s_k(\tau)$$

where $\psi = 0$ for a zero upcrossing, and $\psi = 1$ for a zero downcrossing. Accordingly, each signal trajectory associated with a zero upcrossing is being added to the resulting sum, whereas a trajectory associated with a zero downcrossing is being subtracted from that sum.

The crosslation function $C(\tau)$ will always attain a zero value value at $\tau = 0$; however, other zero values may be observed at other non-zero values of the relative time $\tau$. Fig. 2b is an example of a crosslation function obtained by averaging a number of signal trajectories suitably aligned in the tau-domain.

It should be pointed out that in the case of processing signals with stationary properties it is not necessary to use all consecutive zero crossings to determined a crosslation function. For example, when a relatively long record of a stationary random signal is available, it is possible to select zero crossings separated by at least some predetermined time interval.

Note that in the context of crosslation-based spectral analysis, the relative time $\tau$ has a meaning of elapsed time, since each trajectory starts at an actually observed "now" time instant and goes back in (real) time, so that only accumulated "past experience" is exploited for inference regarding a signal under examination.

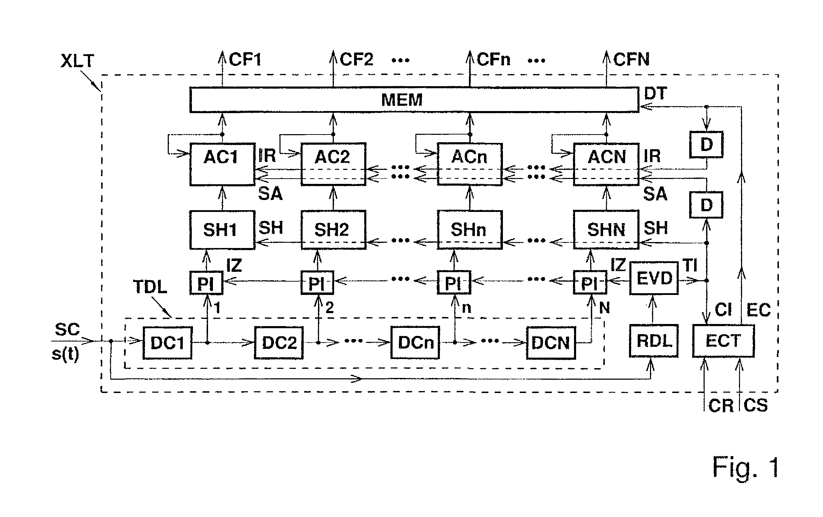

A functional block diagram of a crosslator system XLT is shown in Fig. 1. The system comprises a cascade of N delay cells, DC1, ..., DCn, ..., DCN, forming a tapped delay line TDL, an array of identical polarity-reversal circuits PI, a plurality of sample-and-hold circuits, SH1, ..., SHn, ..., SHN, a plurality of accumulators AC1, ..., ACn, ..., ACN, a memory MEM, a constant delay line RDL, an event detector EVD, an event counter ECT, and two auxiliary delay units D.

Each of N taps of the delay line TDL provides a time-delayed replica of the analyzed signal s(t) applied to input SC. At any time instant, the values observed at the N taps of the line TDL form jointly a representation of a finite segment of the input signal s(t) propagating along the line TDL. Preferably, the relative delay between consecutive taps of the TDL has a constant value.

In a parallel signal path, the input signal s(t) is delayed in the constant delay line RDL by a time amount equal approximately to a half of the total delay introduced by the tapped delay line TDL. The output of the delay line RDL drives the event detector EVD.

When the event detector EVD detects a zero crossing in the delayed signal s(t), a short trigger pulse TI is produced at output TI, and output IZ supplies a signal indicating the type (up or down) of a detected zero crossing.

Each circuit PI of the array of identical polarity-reversal circuits is driven by a respective tap of the delay line TDL and it supplies a signal to a corresponding sample-and-hold circuit. In response to a signal at control input IZ, each circuit PI either passes its input signal with a reversed polarity (when a zero downcrossing is detected), or passes its input signal in its original form (when a zero upcrossing is detected).

A short trigger pulse TI is generated by the event detector EVD to initiate, via the common input SH, a simultaneous operation of all sample-and-hold circuits, SH1, ..., SHn, ..., SHN. Each sample-and-hold circuit SHn captures the instantaneous value of the signal appearing at its input; this value is then acquired by a respective accumulator ACn at the time instant determined by a delayed trigger pulse TI applied to the common input SA. The trigger pulse TI also increments by one via input CI the current state of an event counter ECT.

The capacity of the event counter ECT is equal to a predetermined number of zero crossings to be detected in the input signal s(t). Accordingly, the time interval needed to detect the predetermined number of zero crossings will determine the duration of one complete cycle of operation of the crosslator system.

The capacity of the event counter ECT can be set to a required value by applying a suitable external control signal to input CS. Additionally, the state of the event counter ECT can be reset, via input CR, to an initial 'zero state'; this 'zero sate' will also reset to zero all the accumulators. The event counter ECT can as well be arranged to operate continually in a 'free-running' fashion.

A trigger pulse TI delayed in the delay unit D initiates, via common input SA, the simultaneous operation of all accumulators driven by respective sample-and-hold circuits. The function of each accumulator ACn is to perform addition of signal values appearing successively at its input during each full operation cycle of the crosslator system. As explained below, all the accumulators are reset to zero, via common input IR, before the start of each new cycle of operation.

When a predetermined number of zero crossings has been detected by the event detector EVD, and registered by the event counter ECT, an end-of-cycle pulse EC is produced at the output of the counter ECT. This pulse initiates, via input DT, the transfer of the accumulators' data to the memory MEM. As a result, a discrete-time version of the determined crosslation function C($\tau$) will appear at the N outputs, CF1, ..., CFn, ..., CFN of the memory MEM.

An end-of-cycle pulse EC, suitably delayed in the delay unit D, is used to reset to zero, via common input IR, all the accumulators. Also, when operating in a 'free-running' mode, the event counter ECT after reaching its maximum value (capacity) will revel to its initial 'zero state'. At this stage, the crosslator system XLT, having completed its full cycle of operation, is ready to start a new cycle. It should be pointed out that the operation of the crosslator XLT can be terminated and re-started at any time by applying a suitable control signal to input CR of the event counter ECT.

Fig. 2a is an example of an overlay of time-aligned segments $\{s_k(\tau)\}$ of a fluctuating signal s(t) comprising a dominant-frequency component; Fig. 2b depicts the resulting crosslation function C($\tau$) used to represent the signal being processed.

The crosslation function contains information generally associated with timing, or phase, relationships between different segments of the same signal. However, for the purpose of signal detection and analysis in the frequency domain, it would be advantageous to develop a crosslation-based spectral method. Preferably, such method should have sufficiently low computational complexity to be implemented with a low-cost hardware/software.

It would therefore be desirable to provide a crosslation-based method capable of performing spectral analysis in real-time to be employed for recognition and classification of signals of non-stationary nature.

Embodiments of the present invention exploit the fact that the crosslation function C($\tau$) of a signal s(t) under examination can have the same shape as the cross-correlation function between the signal s(t) and the time derivative d(t) of a binary waveform b(t) being a hard-limited version of that signal.

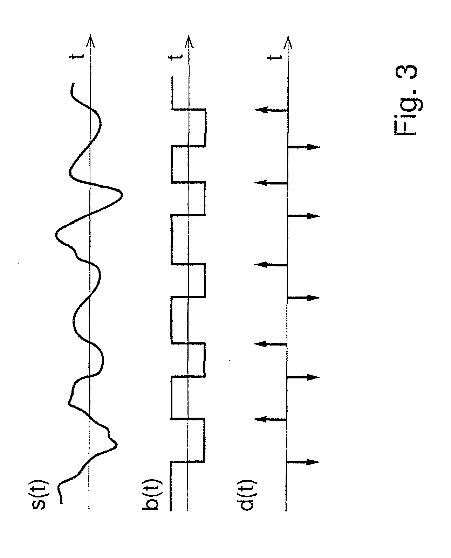

Fig. 3 depicts an example of a signal s(t), a binary waveform b(t) obtained from that signal by hard limiting, and a sequence d(t) of bipolar impulses (Dirac delta functions) representing the derivative of the binary waveform b(t).

For a broad class of signals, the cross-correlation function $R_{sb}(\tau)$ between the signal s(t) and its binary version b(t), obtained by hard limiting, is proportional to the normalize autocorrelation function $\rho_{ss}(\tau)$ of that signal. Such class of signals includes:

- Gaussian random processes;
- a frequency-modulated or phase-modulated wave in which the modulation is independent of the carrier phase;
- a waveform alternating between two amplitude levels in random or non-random manner.

More specifically, the cross-correlation function $R_{sb}(\tau)$ between a signal s(t) and its binary version b(t) can be expressed as

$$R_{sb}(\tau) = \gamma \, \rho_{ss}(\tau)$$

where $\rho_{ss}(\tau)$ is the normalized autocorrelation function $\rho_{ss}(\tau)$ of the signal s(t) and $\gamma$ is the mean absolute value of that signal.

For a sufficiently long observation time interval T, the mean absolute value $\gamma$ of a signal s(t) being analyzed can be estimated from

$$\gamma = \frac{1}{T} \int_0^T |s(t)| dt$$

For example, for Gaussian noise, $\gamma = \sigma_n \sqrt{2/\pi}$, where $\sigma_n$ is the rms value of the noise; for a sinewave with amplitude A, $\gamma = 2A/\pi$.

For the class of signals under consideration, the cross-correlation function $R_{sd}(\tau)$ between the signal s(t) and the sequence d(t) of impulses, can be expressed as

$$R_{sd}(\tau) = -\frac{d}{d\tau} R_{sb}(\tau) = -\gamma \frac{d}{d\tau} \rho_{ss}(\tau) = -\frac{\gamma}{\sigma_s^2} \frac{d}{d\tau} R_{ss}(\tau)$$

where $\sigma_s^2$ is the signal power, and $R_{ss}(\tau)$ is the autocorrelation function of the signal.

The value of $\sigma_s^2$ can be estimated from

$$\sigma_s^2 = \frac{1}{T} \int_0^t s^2(t) dt$$

where T is a sufficiently long observation interval. For Gaussian noise, $\sigma_s^2 = \sigma_n^2$, where $\sigma_n$ is the rms value of the noise, and for a sinewave with amplitude A,

$$\sigma_s^2 = A^2/2.$$

It can be shown that the crosslation function C(τ) of a signal s(t) is equal to the cross-correlation function $R_{sd}(\tau)$; hence $C(\tau) = R_{sd}(\tau)$, and

$$C(\tau) = -\gamma \frac{d}{d\tau} \rho_{ss}(\tau) = -\frac{\gamma}{\sigma_s^2} \frac{d}{d\tau} R_{ss}(\tau)$$

Consequently, in many cases of practical interest, crosslation analysis can replace conventional correlation analysis. One example is crosslation-based spectral analysis performed in real time.

Wiener-Khintchine theorem states that the autocorrelation function $R_{ss}(\tau)$ of a signal s(t) and its power spectral density G(f) form a Fourier pair, i.e. $G(f) = F[R_{ss}(\tau)]$, where $F[\cdot]$ denotes the Fourier transform operation. Therefore, the power spectral density G(f) of a signal s(t) of interest can be determined from

$$G(f) = \frac{\sigma_s^2}{\gamma f} \mid F[R_{sd}(\tau)] \mid$$

or equivalently, in terms of the crosslation function

$$G(f) = \frac{\sigma_s^2}{\gamma f} \ | \ \mathcal{F} \ [C(\tau)] \ |$$

However, it should be pointed out that a crosslation function can be implemented in a much simpler way than that used to implement a corresponding correlation function.

Since the crosslation function $C(\tau)$ is an odd function of time $\tau$, the complex Fourier transform will be reduced to its imaginary part alone. Consequently, the required Fourier transformation can be conveniently implemented as Fast Sine Transform (FST).

Example Crosslator for use in the First and Second Embodiments

An example of a crosslator that can be used in the subsequently-described first and second embodiments of the present invention will now be described. It will be appreciated, however, that in accordance with the claims, other forms of crosslator could be used instead.

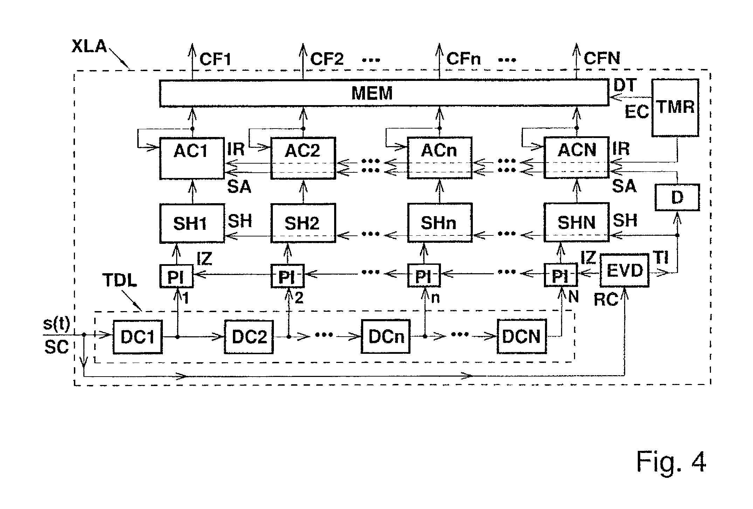

Fig. 4 is a block diagram of the crosslator of Fig. 1, suitably modified for the use in various embodiments of a real-time spectrum analyzer.

The modified crosslator XLA comprises a cascade of N delay cells, DC1, ..., DCn, ..., DCN, forming a tapped delay line TDL, an array of identical polarity-reversal circuits PI, a plurality of sample-and-hold circuits, SH1, ..., SHn, ..., SHN, a plurality of accumulators AC1, ..., ACn, ..., ACN, a memory MEM, an event detector EVD, a delay unit D, and a timer TMR.

Each of N taps of the delay line TDL provides a time delayed replica of the analyzed signal s(t) applied to input SC. At any time instant, the values observed at the N taps of the delay line TDL form jointly a representation of a finite segment of the input signal s(t) propagating along the delay line TDL. The relative delay between consecutive taps of the delay line TDL has a constant value $\Delta$, which determines a quantization step of each signal representation, and also its total duration $N\Delta$.

When the event detector EVD detects a zero crossing in an input signal s(t), a short trigger pulse TI is produced at output TI, and output IZ supplies a signal indicating the type (up or down) of a detected zero crossing.

Each circuit PI of the array of identical polarity-reversal circuits is driven by a respective tap of the delay line TDL and it supplies a signal to a corresponding sample-and-hold circuit SHn. In response to a signal at control input IZ, each circuit PI either passes its input signal with a reversed polarity (when a zero downcrossing is detected), or passes its input signal in its original form (when a zero upcrossing is detected).

A short trigger pulse TI is generated by the event detector EVD to initiate, via the common input SH, a simultaneous operation of all sample-and-hold circuits, SH1, ..., SHn, ..., SHN. Each sample-and-hold circuit SHn captures the instantaneous value of the signal appearing at its input; this value is then acquired by a respective accumulator ACn at the time instant determined by a delayed trigger pulse TI applied to the common input SA.

A trigger pulse TI delayed in the delay unit D initiates, via common input SA, the simultaneous operation of all accumulators driven by respective satrple-and-hold circuits. The function of each accumulator ACn is to perform addition of signal values appearing successively at its input during each full operation cycle of the crosslator system. As explained below, all the accumulators are reset to zero, via common input IR, before the start of each new cycle of operation.

When a predetermined time interval T has elapsed, an end-of-cycle pulse EC is produced at the output of the timer TMR. This pulse initiates, via input DT, the transfer of the accumulators' data to the memory MEM. As a result, a discrete-time version of the determined crosslation function $C(\tau)$ will appear at the N outputs, CF1, ..., CFn, ..., CFN of the memory MEM.

The timer TMR also produces a delayed version of an end-of-cycle pulse EC to reset to zero, via common input IR, all the accumulators. At this stage, the crosslator system XLA, having completed its full cycle of operation, starts a new cycle.

In this configuration, the event detector EVD detects zero crossings in the input signal s(t) as it is evolving continually in real time at input SC. Consequently, the resulting crosslation function $C(\tau)$, being determined in real time t, is a function of elapsed time $\tau$, the origin, $\tau=0$, of which moves perpetually in real time t so that the delay line TDL always contains 'past' signal samples.

In contrast to the arrangement of Fig. 1, in the configuration of Fig. 4, the crosslator XLA processes an input signal s(t) within a predetermined time interval T; therefore, the number of zero crossings observed in an input signal s(t) will vary depending on the signal spectral characteristics.

Outputs CF1, CF2, ... , CFN of the crosslator XLA provide, respectively, samples $C(\Delta)$, $C(2\Delta)$, ... , $C(N\Delta)$ of the crosslation function $C(\tau)$ characterizing an input signal s(t). The number N of taps in the delay line TDL and the incremental delay $\Delta$ between consecutive taps are so chosen as to obtain a sufficiently long segment $N\Delta$ of the crosslation function

C($\tau$); 0 < $\tau$ < N$\Delta$. The incremental delay $\Delta$ determines the quantization step of the discrete-time crosslation function.

<u>First Preferred Embodiment</u>

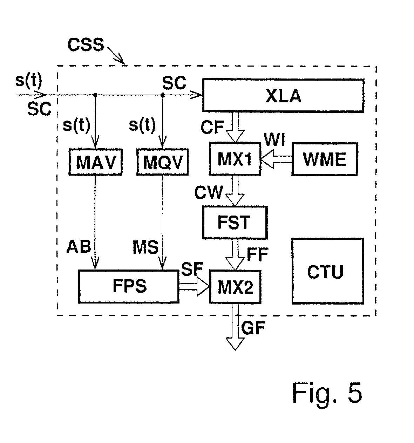

Fig. 5 is a block diagram of a crosslation-based spectrum analyzer CSS according to a first embodiment of the invention. The analyzer comprises the following functional blocks:

- a control unit CTU;
- a crosslator XLA, which, in this embodiment, comprises the crosslator described above with reference to Figure 4;
- a mean-absolute-value calculator MAV;
- a mean-square-value calculator MQV;
- two multipliers, MX1 and MX2;
- a read-only memory WME storing time-window functions;
- a Fast Sine Transformer FST;
- a frequency-profile scaling block FPS.

A signal s(t) under examination is applied to input SC of the spectrum analyzer CSS. The crosslator XLA processes the input signal within a time interval T to produce a discrete-time one-sided representation {C(n)} of the crossslation function C($\tau$)

$$\{C(n)\} = C(1), \quad C(2), \quad ..., \quad C(n), \quad ..., \quad C(N)$$

The sequence {C(n)} that appears at output CF of the crosslator XLA is multiplied in the multiplier MX1 by a suitable (one-sided) time-window sequence {W(n)}

$$\{W(n)\} = W(1), \quad W(2), \quad ..., \quad W(n), \quad ..., \quad W(N)$$

The above window sequence is produced at output WI of the read-only memory WME.
This step is preferable because it reduces the effects of truncating the support of the crosslation function C($\tau$) to a maximum value N$\Delta$ of elapsed time $\tau$, where N is the number of taps (cells) in the delay line TDL of the crosslator XLA, and $\Delta$ is the incremental delay between consecutive taps.
There are many suitable time windows well known to those skilled in the art. For example, a Bessel window or a Kaiser window can be used.
It should be pointed out that the multiplication by a window sequence {W(n)}can be dispensed with when the determined crosslation sequence {C(n)} decays gradually to a zero value as the delay-time index n increases to N.
The resulting one-sided sequence of 'windowed' crosslation function

$$W(1)C(1), \quad W(2)C(2), \quad ..., \quad W(n)C(n), \quad ..., \quad W(N)C(N)$$

available at output CW of the multiplier MX1, is applied to the Fast Sine Transformer FST to produce at its output FF a sequence

$$\{F(j)\} = F(1), \quad F(2), \quad ..., \quad F(j), \quad ..., \quad F(J)$$

that represents a 'raw' frequency spectrum F(f) in which higher-frequency components are accentuated.
The sequence {F(j)} is applied to one input of the multiplier MX2 whose other input is driven by output SF of the frequency-profile scaling block FPS. A representation {G(j)} of the power spectral density G(f) is obtained by scaling the sequence {F(j)} as follows

$$\{G(j)\} \;=\; \alpha\frac{F(1)}{1}, \quad \alpha\frac{F(2)}{2}, \quad \cdots, \quad \alpha\frac{F(j)}{j}, \quad \cdots, \quad \alpha\frac{F(J)}{J}$$

where

$$\alpha \;=\; \frac{\sigma_s^2}{\gamma} \;=\; \left[\int_0^T s^2(t)\,dt\right] \Big/ \left[\int_0^T |s(t)|\,dt\right]$$

The discrete-frequency representation $\{G(j)\}$ of the power spectral density G(f) of the input signal s(t) appears at output GF of the multiplier MX2.

The parameter $\sigma_s^2$ is determined from the signal s(t) by the mean-square-value calculator MQV; the value of this parameter is applied to input MS of the frequency-profile scaling block FPS. The mean-absolute-value calculator MAV determines from the input signal s(t) the value of parameter $\gamma$, this value is applied to input AB of the frequency-profile scaling block FPS.

These two parameters of interest can be determined in an analogue or digital manner as well known to those skilled in the art.

It is noted that in the case of Gaussian noise, the scaling factor $\alpha$ can be expressed as

$$\alpha \;=\; \frac{\sigma_s^2}{\gamma} \;=\; \sigma_s\sqrt{\frac{\pi}{2}}$$

Therefore, when a Gaussian signal is being processed only one parameter, $\sigma_s^2$, will need to be estimated.

In some hardware implementations, it may be advantageous to normalize the crosslation function as

$$\frac{C(1)}{\gamma}, \quad \frac{C(2)}{\gamma}, \quad \cdots, \quad \frac{C(n)}{\gamma}, \quad \cdots, \quad \frac{C(N)}{\gamma}$$

prior to performing Fourier transformation in the Fast Sine Transformer FST. If applicable, such normalization can be combined with multiplying the crosslation sequence {C(n)} by a suitable window sequence {W(n)}. In such a case, the scaling of the 'raw' frequency spectrum F(f) will be modified accordingly.

The crosslation-based spectrum analyzer CSS also incorporates a control unit CTU. The control unit CTU initiates and synchronizes the functions and operations of all the blocks of the spectrum analyzer CSS.

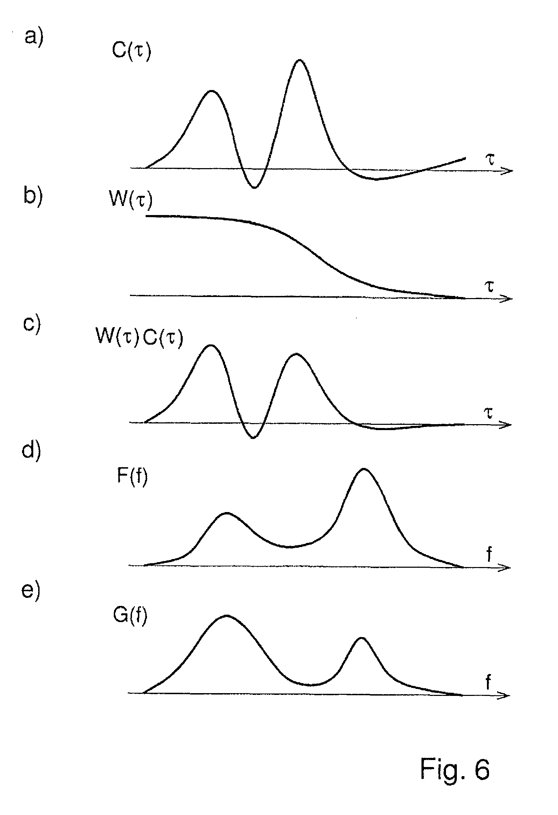

Fig. 6 depicts symbolically results of the basic operations performed by the crosslation-based spectrum analyzer CSS constructed in accordance with the present embodiment. To facilitate the interpretation of the results, continuous rather than discrete values of time $\tau$ and frequency f are used for representing respective functions.

Second Preferred Embodiment

Multiplying the 'raw' frequency spectrum F(f) by a factor 1/f, used in a first embodiment, may present some practical difficulties, especially in a lower frequency range, close to zero. While the resulting spectrum distortions can be negligible for bandpass signals, in the case of signals with strong low-frequency components, such distortions can be excessive, at least in some applications. This problem is avoided in the second embodiment described below.

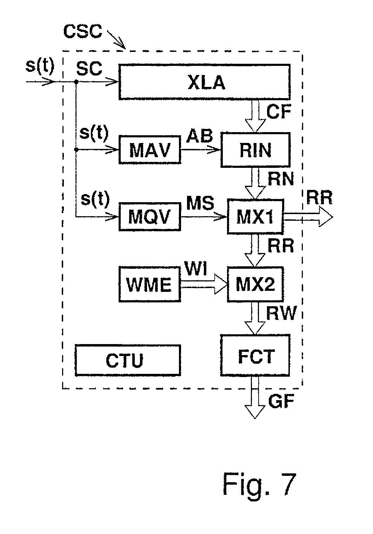

Fig. 7 is a block diagram of another crosslation-based spectrum analyzer CSC constructed in accordance with a second embodiment. The analyzer comprises the following functional blocks:

9

- a control unit CTU;
- a crosslator XLA, which, in this embodiment, comprises the crosslator described previously with reference to Figure 4;
- a mean-absolute-value calculator MAV;
- a mean-square-value calculator MQV;
- two multipliers, MX1 and MX2;
- a read-only memory WME storing time-window functions;
- a Fast Cosine Transformer FCT;
- a 'running-time' integrator RIN.

In this embodiment, prior to performing Fourier transformation, the crosslation function $C(\tau)$ is converted into a normalized autocorrelation function $\rho_{ss}(\tau)$ of the underlying signal s(t) as follows

$$\rho_{ss}(\tau) \;=\; 1 \;-\; \frac{1}{\gamma} \int_0^\tau C(u)du; \quad \tau \geq 0$$

where $\gamma$ is the mean absolute value of the signal.

Accordingly, a 'running' integration is performed on a normalized crosslation sequence of the form

$$\frac{C(1)}{\gamma}, \quad \frac{C(2)}{\gamma}, \quad \dots, \quad \frac{C(n)}{\gamma}, \quad \dots, \quad \frac{C(N)}{\gamma}$$

For example, a normalized autocorrelation sequence $\{\rho_{ss}(n)\}$ can be determined in a recursive manner as

$$\rho_{ss}(n) \;=\; \rho_{ss}(n-1) - \frac{1}{\gamma} C(n); \quad n = 1, 2, \dots, N$$

where $\rho_{ss}(0) = 1$.

Since the autocorrelation function $\rho_{ss}(\tau)$ is an even function of time $\tau$, the complex Fourier transform reduces to its real part alone. Therefore, in practice, the required Fourier transformation can be conveniently implemented as Fast Cosine Transform (FCT).

The operations of normalization and integration are performed by the 'running-time' integrator RIN that receives at its input CF a crosslation function supplied by the crosslator XLA. The integrator RIN also receives at its other input AB the parameter $\gamma$ supplied by the mean-absolute-value calculator MAV. The integrator RIN produces at its output RN a representation $\{\rho_{ss}(n)\}$ of a normalized autocorrelation function $\rho_{ss}(\tau)$, $\tau \geq 0$.

The multiplier MX1 uses an estimate MS of signal power to suitably scale the normalized correlation function $\rho_{ss}(\tau)$ appearing at input RN. An autocorrelation function $R_{ss}(\tau)$ of the input signal s(t) is available at each of two identical outputs RR. A separate output is useful when the autocorrelation function *per se* is utilized for signal characterization.

The estimate MS of the signal power is supplied by the mean-square-value calculator MQV.

The multiplier MX2 multiplies the autocorrelation function (received at input RR) by a suitable window function received at input WI from the read-only memory WME. A 'windowed' version of the autocorrelation function is applied to input RW of the Fast Cosine Transformer FCT. The power spectral density G(f) of an input signal s(t) is provided at output GF of the spectrum analyzer CSC.

The crosslation-based spectrum analyzer CSC also incorporates a control unit CTU. The control unit CTU initiates and synchronizes the functions and operations of all the blocks of the spectrum analyzer CSC.

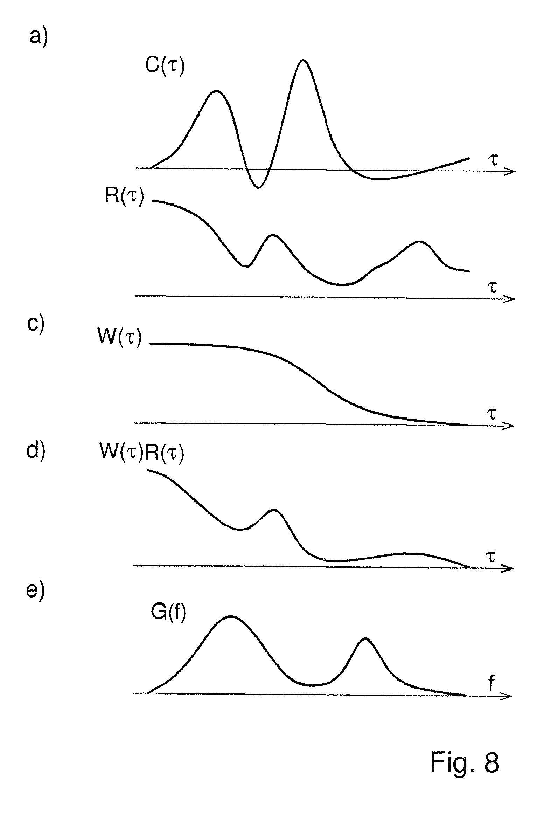

Fig. 8 depicts symbolically results of the basic operations performed by the crosslation-based spectrum analyzer CSC constructed in accordance with the second embodiment. To facilitate the interpretation of the results, continuous rather than discrete values of time $\tau$ and frequency f are used for representing respective functions.

Modifications and Variations

Many modifications and variations can be made to the embodiments described above.

In particular, it will be understood that the foregoing description of preferred embodiments of the invention has been presented for the purpose of illustration and description. It is not intended to be exhaustive or to limit the invention to the precise form disclosed. In light of the foregoing description, it is evident that many alterations, modifications, and variations will enable those skilled in the art to utilize the invention in various embodiments suited to the particular use contemplated.

**Claims**

1. A spectrum analyser, comprising:

   a crosslator (XLA) for processing an input signal to produce discrete-time crosslation function values for the input signal; and
   a fourier transformer (FST; FCT) for performing a fourier transform on the discrete-time crosslation function values to generate frequency-dependent values;
   wherein the crosslator (XLA) comprises means for processing the input signal to generate the discrete-time crosslation function values using the crosslation function C($\tau$):

   $$C(\tau) = \frac{1}{K}\sum_{k=1}^{K}(-1)^{\psi}s(t - t_k) = \frac{1}{K}\sum_{k=1}^{K}(-1)^{\psi}s_k(\tau)$$

   where:
   $t_1$, $t_2$, .....$t_k$, ...$t_K$ are the time instants at which the input signal s(t) crosses a zero level such that s($t_k$) = 0;
   for a zero-crossing occurring at $t_k$, the signal trajectory $s_k(\tau)$ = s($t_k$ + $\tau$);
   $\tau$ is relative time such that each trajectory $s_k(\tau)$ is a time-shifted copy of the input signal s(t), with the time shift being given by $\tau$ = t - $t_k$;
   {s($t_k$ + $\tau$); k = 1, 2, ...K} are mapped by the time shifts into another set of trajectories {$s_k(\tau)$; k = 1, 2, ...K};
   $\psi$ = 0 for an upcrossing of the zero level
   $\psi$ = 1 for a downcrossing of the zero level; and
   wherein said crosslator (XLA) comprises a timer (TMR) for setting a time interval (T) within which the crosslator is arranged to process the input signal; and
   an event detector (EVD) connected to an input of the crosslator and comprising means for detecting zero crossings of the input signal as it evolves continually in real time at the input, such that the crosslator is operable to determine the crosslation function values in real time.

2. The spectrum analyser of Claim 1, further comprising:

   a scaler (MAV, MQV, FPS, MX2) for scaling the frequency-dependent values generated by the fourier transformer (FST) to produce power spectral density values.

3. The spectrum analyser of Claim 2, further comprising:

   a mean-absolute value calculator (MAV) for calculating a mean-absolute-value of the input signal; and
   a mean-square-value calculator (MQV) for calculating a mean-square-value of the input signal;
   and wherein the scaler (MAV, MQV, FPS, MX2) comprises means for scaling the frequency-dependent values generated by the fourier transformer (FST) using the mean absolute value and the mean-square-value.

4. The spectrum analyser of Claim 1, further comprising:

   a converter (MAV, MQV, RIN, MX1) for converting the discrete-time crosslation function values produced by the crosslator to autocorrelation function values of the input signal prior to input into the fourier transformer (FCT) so that the frequency-dependent values generated by the fourier transformer (FCT) comprise power spectral density values.

5. The spectrum analyser of Claim 4, further comprising:

a mean-absolute-value calculator (MAV) for calculating a mean-absolute value of the input signal; and wherein the converter (MAV, MQV, RIN, MX1) comprises means for converting the discrete-time crosslation function values produced by the crosslator into normalised autocorrelation function values using the calculated mean-absolute value.

6. The spectrum analyser of any preceding claim, further comprising:

a time-window function generator (WME) for applying a time-window sequence of values to the discrete-time crosslation function values prior to input to the fourier transformer (FCT).

7. A method of processing a signal to perform spectrum analysis, comprising:

performing a crosslation operation on an input signal to produce discrete-time crosslation function values for the input signal; and
performing a fourier transform on the discrete-time crosslation function values to generate frequency-dependent values;
wherein the crosslation operation is performed on the input signal to generate the discrete-time crosslation function values using the crosslation function $C(\tau)$:

$$C(\tau) = \frac{1}{K}\sum_{k=1}^{K}(-1)^{\psi}s(t - t_k) = \frac{1}{K}\sum_{k=1}^{K}(-1)^{\psi}s_k(\tau)$$

where:
$t_1, t_2, .....t_k, ...t_K$ are the time instants at which the input signal s(t) crosses a zero level such that $s(t_k) = 0$;
for a zero-crossing occurring at $t_k$, the signal trajectory $s_k(\tau) = s(t_k + \tau)$;
$\tau$ is relative time such that each trajectory $s_k(\tau)$ is a time-shifted copy of the input signal s(t), with the time shift being given by $\tau = t - t_k$;
$\{s(t_k + \tau); k = 1, 2, ...K\}$ are mapped by the time shifts into another set of trajectories $\{s_k(\tau); k = 1, 2, ...K\}$;
$\psi = 0$ for an upcrossing of the zero level
$\psi = 1$ for a downcrossing of the zero level; and
the crosslation operation comprises the steps of:

setting a time interval (T) within which the input signal is processed; and
detecting zero crossings of the input signal as it evolves continually in real time, such that the crosslation operation determines the crosslation function values in real time.

8. The method of Claim 7, further comprising:

scaling the frequency-dependent values generated by the fourier transform to produce power spectral density values.

9. The method of Claim 8, further comprising:

calculating a mean-absolute-value of the input signal; and
calculating a mean-square-value of the input signal;
and wherein the frequency-dependent values generated by the fourier transform are scaled using the mean absolute value and the mean-square-value.

10. The method of Claim 7, further comprising:

converting the discrete-time crosslation function values produced by the crosslation operation to autocorrelation function values of the input signal prior to performing the fourier transform so that the frequency-dependent values generated by the fourier transform comprise power spectral density values.

11. The method of Claim 10, further comprising:

calculating a mean-absolute value of the input signal;
and wherein the discrete-time crosslation function values produced by the crosslation operation are converted into normalised autocorrelation function values using the calculated mean-absolute value.

**Patentansprüche**

1. Spektrumanalysator, der Folgendes umfasst:

einen Crosslator (XLA) zum Verarbeiten eines Eingangssignals, um Diskretzeit-Crosslation-Funktionswerte für das Eingangssignal zu erzeugen; und
einen Fouriertransformator (FST; FCT) zum Durchführen einer Fouriertransformation an den Diskretzeit-Crosslation-Funktionswerten, um frequenzabhängige Werte zu erzeugen;
wobei der Crosslator Mittel zum Verarbeiten des Eingangssignals umfasst, um die Diskretzeit-Crosslation-Funktionswerte unter Verwendung folgender Crosslation-Funktion C($\tau$) zu erzeugen:

$$C(\tau) = \frac{1}{K}\sum_{k=1}^{K}(-1)^{\psi}s(t-t_k) = \frac{1}{K}\sum_{k=1}^{K}(-1)^{\psi}s_k(\tau)$$

wobei
$t_1, t_2, \ldots t_k, \ldots t_K$ die Zeitpunkte sind, zu denen das Eingangssignal s(t) einen Nullpegel durchläuft, sodass $s(t_k) = 0$ ist;
für einen Nulldurchgang, der bei $t_k$ auftritt, die Signaltrajektorie $s_k(\tau)$ - $s(t_k + \tau)$ ist;
$\tau$ relative Zeit ist, sodass jede Trajektorie $s_k(\tau)$ eine zeitverschobene Kopie des Eingangssignals s(t) ist, wobei die Zeitverschiebung durch $\tau = t - t_k$ gegeben ist;
$\{s(t_k + \tau); k = 1,2, \ldots K\}$ durch die Zeitverschiebung in eine andere Menge von Trajektorien $(s_k(\tau); k = 1,2, \ldots K\}$ abgebildet werden;
für einen Aufwärtsdurchgang des Nullpegels $\psi = 0$ ist;
für einen Abwärtsdurchgang des Nullpegels $\psi = 1$ ist und wobei der Crosslator (XLA) einen Zeitgeber (TMR) zum Einstellen eines Zeitintervalls (T), innerhalb dessen das Eingangssignal zu verarbeiten der Crosslator ausgelegt ist; und
einen Ereignisdetektor (EVD) umfasst, der mit einem Eingang des Crosslators verbunden ist und Mittel zum Detektieren von Nulldurchgängen des Eingangssignals umfasst, sowie es sich kontinuierlich in Echtzeit am Eingang entwickelt, sodass der Crosslator betreibbar ist, um die Crosslation-Funktionswerte in Echtzeit zu ermitteln.

2. Spektrumanalysator nach Anspruch 1, der ferner Folgendes umfasst:

einen Skalierer (MAV, MQV, FPS, MX2) zum Skalieren der frequenzabhängigen Werte, die durch den Fouriertransformator (FST) erzeugt worden sind, um Leistungsspektraldichtewerte zu erzeugen.

3. Spektrumanalysator nach Anspruch 2, der ferner Folgendes umfasst :

einen Absolutmittelwertberechner (MAV) zum Berechnen eines Absolutmittelwertes des Eingangssignals; und
einen Quadratmittelwertberechner (MQV) zum Berechnen eines Quadratmittelwertes des Eingangssignals;
und wobei der Skalierer (MAV, MQV, FPS, MX2) Mittel zum Skalieren der frequenzabhängigen Werte umfasst, die durch den Fouriertransformator (FST) unter Verwendung des Absolutmittelwertes und des Quadratmittelwertes erzeugt worden sind.

4. Spektrumanalysator nach Anspruch 1, der ferner Folgendes umfasst:

einen Wandler (MAV, MQV, RIN, MXI) zum Umwandeln der Diskretzeit-Crosslation-Funktionswerte, die durch den Crosslator erzeugt worden sind, in Autokorrelationsfunktionswerte des Eingangssignals vor Eingabe in den Fouriertransformator (FCT), sodass die frequenzabhängigen Werte, die durch den Fouriertransformator (FCT) erzeugt worden sind, Leistungsspektraldichtewerte umfassen.

5. Spektrumanalysator nach Anspruch 4, der ferner Folgendes umfasst:

einen Absolutmittelwertberechner (MAV) zum Berechnen eines Absolutmittelwertes des Eingangssignals; und wobei der Wandler (MAV, MQV, RIN, MXI) Mittel zum Umwandeln der Diskretzeit-Crosslation-Funktionswerte, die durch den Crosslator erzeugt worden sind, in normierte Autokorrelationsfunktionswerte unter-Verwendung des berechneten Absolutmittelwertes umfasst.

6. Spektrumanalysator nach irgendeinem vorhergehenden Anspruch, der ferner Folgendes umfasst:

einen Zeitfensterfunktionsgenerator (WME) zum Anwenden einer Zeitfensterfolge von Werten auf die Diskretzeit-Crosslation-Funktionswerte vor Eingabe in den Fouriertransformator (FCT).

7. Verfahren des Verarbeitens eines Signals, um Spektrumanalyse durchzuführen, das Folgendes umfasst:

Durchführen einer Crosslation-Operation an einem Eingangssignal, um Diskretzeit-Crosslation-Funktionswerte für das Eingangssignal zu erzeugen; und
Durchführen einer Fouriertransformation an den Diskretzeit-Crosslation-Funktionswerten, um frequenzabhängige Werte zu erzeugen;
wobei die Crosslation-Operation am Eingangssignal durchgeführt wird, um die Diskretzeit-Crosslation-Funktionswerte unter Verwendung folgender Crosslation-Funktion $C(\tau)$ zu erzeugen:

$$C(\tau) = \frac{1}{K} \sum_{k=1}^{K} (-1)^{\psi} s(t - t_k) = \frac{1}{K} \sum_{k=1}^{K} (-1)^{\psi} s_k(\tau)$$

wobei
$t_1, t_2, \ldots t_k, \ldots t_K$ die Zeitpunkte sind, zu denen das Eingangssignal $s(t)$ einen Nullpegel durchläuft, sodass $s(t_k) = 0$ ist;
für einen Nulldurchgang, der bei $t_k$ auftritt, die Signaltrajektorie $s_k(\tau)$ - $s(t_k + \tau)$ ist;
$\tau$ relative Zeit ist, sodass jede Trajektorie $s_k(\tau)$ eine zeitverschobene Kopie des Eingangssignals $s(t)$ ist, wobei die Zeitverschiebung durch $\tau = t - t_k$ gegeben ist;
$\{s(t_k + \tau); k = 1,2,\ldots K\}$ durch die Zeitverschiebungen in eine andere Menge von Trajektorien $\{s_k(\tau); k = 1,2,\ldots K\}$ abgebildet werden;
für einen Aufwärtsdurchgang des Nullpegels $\psi = 0$ ist;
für einen Abwärtsdurchgang des Nullpegels $\psi = 1$ ist; und
die Crosslation-Operation die folgenden Schritte umfasst:

Einstellen eines Zeitintervalls (T), innerhalb dessen das Eingangssignal verarbeitet wird; und
Detektieren von Nulldurchgängen des Eingangssignals, sowie es sich kontinuierlich in Echtzeit entwickelt, sodass die Crosslation-Operation die Crosslation-Funktionswerte in Echtzeit ermittelt.

8. Verfahren nach Anspruch 7, das ferner Folgendes umfasst:

Skälieren der frequenzabhängigen Werte, die durch die Fouriertransformation erzeugt worden sind, um Leistungsspektraldichtewerte zu erzeugen.

9. Verfahren nach Anspruch 8, das ferner Folgendes umfasst:

Berechnen eines Absolutmittelwertes des Eingangssignals und
Berechnen eines Quadratmittelwertes des Eingangssignals;
und wobei die frequenzabhängigen Werte, die durch die Fouriertransformation erzeugt worden sind, unter Verwendung des Absolutmittelwertes und des Quadratmittelwertes skaliert werden.

10. Verfahren nach Anspruch 7, das ferner Folgendes umfasst:

Umwandeln der Diskretzeit-Crosslation-Funktionswerte, die durch die Crosslation-Operation erzeugt worden sind, in Autokorrelationsfunktionswerte des Eingangssignals vor Durchführen der Fouriertransformation, sodass die frequenzabhängigen Werte, die durch die Fouriertransformation erzeugt worden sind, Leistungsspektraldichtewerte umfassen.

11. Verfahren nach Anspruch 10, das ferner Folgendes umfasst:

Berechnen eines Absolutmittelwertes des Eingangssignals;
und wobei die Diskretzeit-Crosslation-Funktionswerte, die durch die Crosslation-Operation erzeugt worden sind, unter Verwendung des berechneten Absolutmittelwertes in normierte Autokorrelationsfunktionswerte umgewandelt werden.


**Revendications**

1. Analyseur de spectre, comprenant :

un crosslateur (XLA) pour le traitement d'un signal d'entrée pour produire des valeurs de fonction de crosslation en temps discret pour le signal d'entrée ; et
un transformateur de Fourier (FST ; FCT) pour appliquer une transformation de Fourier aux valeurs de fonction de crosslation en temps discret pour générer des valeurs dépendantes de la fréquence ;
dans lequel le crosslateur (XLA) comprend des moyens pour traiter le signal d'entrée pour générer les valeurs de fonction de crosslation en temps discret en utilisant la fonction de crosslation $C(\tau)$ :

$$C(\tau) = \frac{1}{K}\sum_{k=1}^{K}(-1)^{\psi}s(t - t_k) = \frac{1}{K}\sum_{k=1}^{K}(-1)^{\psi}s_k(\tau)$$

où :
$t_1\, t_2\, ..., t_{k,} ... t_K$ sont les instants auxquels le signal d'entrée s(t) croise un niveau zéro de sorte que $s\,(t_k) = 0$ ;
pour un passage par zéro apparaissant à $t_k$, la trajectoire de signal $s_k(\tau) = s\,(t_k + \tau)$ ;
$\tau$ est un temps relatif de sorte que chaque trajectoire $s_k(\tau)$ est une copie décalée dans le temps du signal d'entrée s(t), le décalage temporel étant donné par $\tau = t - t_k$ ;
$\{s(t_k + \tau)$ ; k = 1, 2, ... K} sont mappés par les décalages temporels dans un autre ensemble de trajectoires $\{s_k(\tau)$ ; k = 1, 2, ... K} ;
$\psi = 0$ pour un croisement vers le haut du niveau zéro ;
$\psi = 1$ pour un croisement vers le bas du niveau zéro ; et
dans lequel ledit crosslateur (XLA) comprend un registre d'horloge (TMR) pour définir un intervalle de temps (T) pendant lequel le crosslateur est agencé pour traiter le signal d'entrée ; et
un détecteur d'événement (EVD) connecté à une entrée du crosslateur et comprenant des moyens pour détecter les passages par zéro du signal d'entrée alors qu'il évolue continuellement en temps réel à l'entrée, de sorte que le crosslateur puisse être utilisé pour déterminer les valeurs de fonction de crosslation en temps réel.

2. Analyseur de spectre selon la revendication 1, comprenant en outré :

un élément de mise à l'échelle (MAV, MQV, FPS, MX2) pour mettre à l'échelle les valeurs dépendantes de la fréquence générées par le transformateur de Fourier (FST) pour produire des valeurs de densité spectrale de puissance.

3. Analyseur de spectre selon la revendication 2, comprenant en outré :

un calculateur de valeur moyenne absolue (MAV) pour calculer une valeur moyenne absolue du signal d'entrée ; et

un calculateur de valeur quadratique moyenne (MQV) pour calculer une valeur quadratique moyenne du signal d'entrée ;

et dans lequel l'élément de mise à l'échelle (MAV, MQV, FPS, MX2) comprend des moyens pour mettre à l'échelle les valeurs dépendantes de la fréquence générées par le transformateur de Fourier (FST) en utilisant la valeur absolue moyenne et la valeur quadratique moyenne.

**4.** Analyseur de spectre selon la revendication 1, comprenant en outre :

un convertisseur (MAV, MQV, RIN, MX1) pour convertir les valeurs de fonction de crosslation en temps discret produites par le crosslateur en des valeurs de fonction d'autocorrélation du signal d'entrée avant une application au transformateur de Fourier (FCT) de sorte que les valeurs dépendantes de la fréquence générées par le transformateur de Fourier (FCT) comprennent des valeurs de densité spectrale de puissance.

**5.** Analyseur de spectre selon la revendication 4, comprenant en outre :

un calculateur de valeur absolue moyenne (MAV) pour calculer une valeur absolue moyenne du signal d'entrée ; et dans lequel le convertisseur (MAV, MQV, RIN, MX1) comprend des moyens pour convertir les valeurs de fonction de crosslation en temps discret produites par le crosslateur en des valeurs de fonction d'autocorrélation normalisées en utilisant la valeur absolue moyenne calculée.

**6.** Analyseur de spectre selon l'une quelconque des revendications précédentes, comprenant en outre :

un générateur de fonction de fenêtre temporelle (WME) pour appliquer une séquence de fenêtre temporelle de valeurs aux valeurs de fonction de crosslation en temps discret avant une application au transformateur de Fourier (FCT).

**7.** Procédé de traitement d'un signal pour effectuer une analyse spectrale, comprenant :

l'application d'une opération de crosslation à un signal d'entrée pour produire des valeurs de fonction de crosslation en temps discret pour le signal d'entrée ; et
l'application d'une transformation de Fourier aux valeurs de fonction de crosslation en temps discret pour générer des valeurs dépendantes de la fréquence ;
dans lequel l'opération de crosslation est appliquée au signal d'entrée pour générer les valeurs de fonction de crosslation en temps discret en utilisant la fonction de crosslation $C(\tau)$ :

$$C(\tau) = \frac{1}{K}\sum_{k=1}^{K}(-1)^{\psi}s(t - t_k) = \frac{1}{K}\sum_{k=1}^{K}(-1)^{\psi}s_k(\tau)$$

où :

$t_1, t_2, \ldots, t_k, \ldots t_K$ sont les instants auxquels le signal d'entrée $s(t)$ croise un niveau zéro de sorte que $s(t_k) = 0$ ;
pour un passage par zéro apparaissant à $t_k$, la trajectoire de signal $s_k(\tau) = s(t_k + \tau)$ ;
$\tau$ est un temps relatif de sorte que chaque trajectoire $s_k(\tau)$ est une copie décalée dans le temps du signal d'entrée $s(t)$, le décalage temporel étant donné par $\tau = t - t_k$ ;
$\{s(t_k + \tau) ; k = 1, 2, \ldots K\}$ sont mappés par les décalages temporels dans un autre ensemble de trajectoires $\{s_k(\tau) ; k = 1, 2, \ldots K\}$ ;
$\psi = 0$ pour un croisement vers le haut du niveau zéro ;
$\psi = 1$ pour un croisement vers le bas du niveau zéro ; et
l'opération de crosslation comprend les étapes :

d'établissement d'un intervalle de temps (T) pendant lequel le signal d'entrée est traité ; et
de détection des passages par zéro du signal d'entrée alors qu'il évolue continuellement en temps réel, de sorte que l'opération de crosslation détermine les valeurs de fonction de crosslation en temps réel.

8. Procédé selon la revendication 7, comprenant en outre :

la mise à l'échelle des valeurs dépendantes de la fréquence générées par la transformation de Fourier pour produire des valeurs de densité spectrale de puissance.

9. Procédé selon la revendication 8, comprenant en outre :

le calcul d'une valeur moyenne absolue du signal d'entrée ; et
le calcul d'une valeur quadratique moyenne du signal d'entrée ;
et dans lequel les valeurs dépendantes de la fréquence générées par la transformation de Fourier sont mises à l'échelle en utilisant la valeur absolue moyenne et la valeur quadratique moyenne.

10. Procédé selon la revendication 7, comprenant en outre :

la conversion des valeurs de fonction de crosslation en temps discret produites par l'opération de crosslation en des valeurs de fonction d'autocorrélation du signal d'entrée avant l'exécution de la transformation de Fourier de sorte que les valeurs dépendantes de la fréquence générées par la transformation de Fourier comprennent des valeurs de densité spectrale de puissance.

11. Procédé selon la revendication 10, comprenant en outre :

le calcul d'une valeur absolue moyenne du signal d'entrée ;
et dans lequel les valeurs de fonction de crosslation en temps discret produites par l'opération de crosslation sont converties en des valeurs de fonction d'autocorrélation normalisées en utilisant la valeur absolue moyenne calculée.

Fig. 1

a)

$\{s_k(\tau)\}$

$\tau$

b)

$C(\tau)$

$\tau$

Fig. 2

Fig. 3

Fig. 4

EP 2 226 640 B1

Fig. 5

a)

$C(\tau)$

$\tau$

b)

$W(\tau)$

$\tau$

c)

$W(\tau)C(\tau)$

$\tau$

d)

$F(f)$

$f$

e)

$G(f)$

$f$

Fig. 6

Fig. 7

a)

C($\tau$)

$\tau$

R($\tau$)

$\tau$

c)

W($\tau$)

$\tau$

d) W($\tau$)R($\tau$)

$\tau$

e)

G(f)

f

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5301123 A
- US 7120555 B
- US 6539320 B
- US 7216047 B

**Non-patent literature cited in the description**

- **W.J. SZAJNOWSKI ; P.A. RATLIFF.** Implicit Averaging and Delay Determination of Random Binary Waveforms. *IEE SIGNAL PROCESSING LETTERS,* July 2002, vol. 9 (7